# EUROPEAN PATENT APPLICATION

(11) **EP 0 594 408 A1**
(43) Date of publication of application: **27.04.1994**
(21) Application number: 93308327.1
(22) Date of filing: 19.10.1993
(51) Int. Cl.: H01R 9/09

(54) **A connection device for a printed wiring board**

(30) Priority: 19.10.1992 JP 306066/92
(71) Applicant: NIPPON CMK CORP., Iruma-Gun Saitama (JP)
(72) Inventor: Kawakami, Shin, c/o Nippon CMK Corp., Iruma-gun, Saitama (JP)
(74) Representative: Boydell, John Christopher

(57) **Abstract**

s7 A connection device which electrically connects given circuits (6,7) on a double-sided (E) or multi-layer printed wiring board via through holes (10) drilled in each board. The connection device includes a main body made of insulating material, and a lead wire (3) which is made of a bundle of twisted fine lines, extending from the main body, and the tip of which is cone-shaped.

## Description

The present invention relates to a connection device which is used to electrically connect the layers of a double-sided printed wiring (circuit) board or a multi- layer printed wiring (circuit) board.

In recent years, to meet the growing requirements of high density and down-sizing of a printed wiring board, double-sided printed wiring boards and multi-layer printed wiring boards have been developed and widely used.

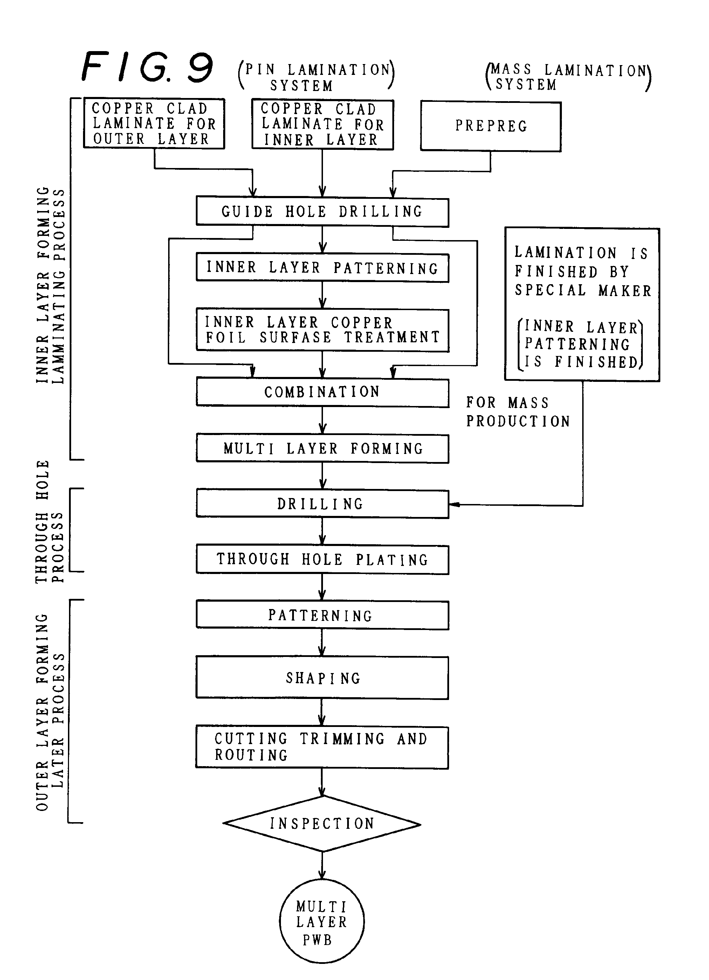

As shown in Figure 9, a multi-layer printed wiring board is produced following the manufacturing steps of inner layer forming and laminating, through holes process, outer layer process and post process.

The through hole process and the subsequent processes for a double-sided printed wiring board are the same as those for a multi-layer printed wiring board.

As means for connecting the layers of a double-sided printed wiring board or a multi-layer printed wiring board to each other, a connection method via through holes is adopted, usually a connection method of plating, or non-electrolysed copper plating or electrolysed copper plating is used.

However, for the plating process, a large scale and expensive processing apparatus is necessary and the working condition is bad. Not only is the plating liquid such as chemical solution required to be severely controlled, but also there are many environmental problems such as drainage.

It is an object of the present invention to provide a connection device which is easily used to electrically connect the layers of a printed wiring board to each other via through holes.

According to the present invention, there is provided a connection device for electrically connecting given circuits on a double-sided or multi-layer printed wiring board via through holes drilled in each of the printed wiring boards, said device comprising: a main body made of insulating material; and a bundle of twisted fine lines which is made of a plurality of fine lines and the lead tip of which is cone-shaped.

According to an embodiment of the present invention means are provided to electrically connect given circuits to each other via through holes drilled in the printed wiring boards, by a connection device for a printed wiring board, since a lead wire made of a plurality of fine lines is inserted into a through hole and solder can be absorbed into the through hole to fill it because of capillary action of the fine lines.

Moreover, as the lead tip of the device is cone-shaped, a connection device is easily inserted into a through hole and does not easily come out because the cone-shaped surface contacts firmly with the inside of the connection land of the through hole.

Furthermore, since the connection device according to the present invention can be produced in the same form as those of existing mounted parts, the connection device can be mounted on a printed wiring board using a part mounter.

As mentioned above, the use of a connection device solves the drawbacks of through hole plating to obtain highly reliable conductivity, and since the connection device can be mounted into a through hole, the mounting work is easy.

Embodiments of the present invention are described referring to the drawings. In each embodiment, like numerals are used for like or corresponding components to skip redundant description.
Figure 1 is a sectional view of a connection device A;
Figure 2 is a sectional view of a connection device B;
Figure 3 is a sectional view of a connection device C according to the present invention;
Figure 4 is an illustration of the connection device A applied to a double-sided wiring board;
Figure 5 is an illustration of the connection device B applied to a double-sided printed wiring board;
Figure 6 is an illustration of the connection device A applied to a multi-layer printed wiring board;
Figure 7 is an illustration of the connection device B applied to a multi-layer printed circuit board;
Figure 8 is an illustration of an example of another connection device; and
Figure 9 is a flow chart showing a manufacturing method of the conventional multi-layer printed wiring board.

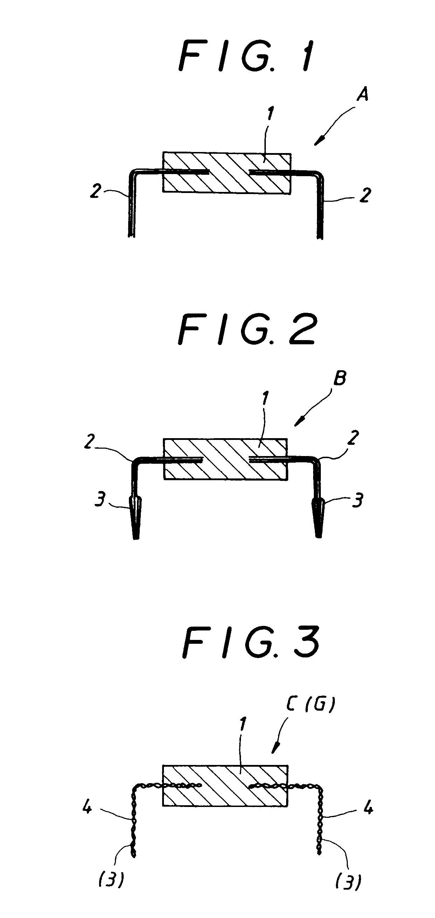

Figures 1-5 show a first embodiment, and a connection device A is shown in Figure 1. The connection device Ais constructed in such a manner that the lead wire 2 made of a bundle of conductive fine lines extends from the right and left sides of a main body 1 made of insulator such as ceramic and resin material.

The fine lines of the connection device A have a diameter smaller than that of a through hole 10 (Figure 2), for example, the fine lines have a diameter of 50-100 f..lm if the through hole 10 has a diameter of 0.8 mm, and the surfaces of the fine lines are preferably treated with flux.

The fine lines from Taiyo Industrial Corp., the trade name of which is the "Wicking Wire-CP-1515", may be used as the fine lines for the present invention.

Figure 2 shows a connection device B. The device B is different from the device A in that the lead ends (tips) 3, of the lead wire 2 of device B made of a bundle of fine lines, are cone-shaped.

The cone-shaped lead wire 3 is tapered to a point to have a smaller diameter at the tip end, a larger diameter at the other end, a length of 2.0-3.5 mm, and is easily inserted into the through hole 10.

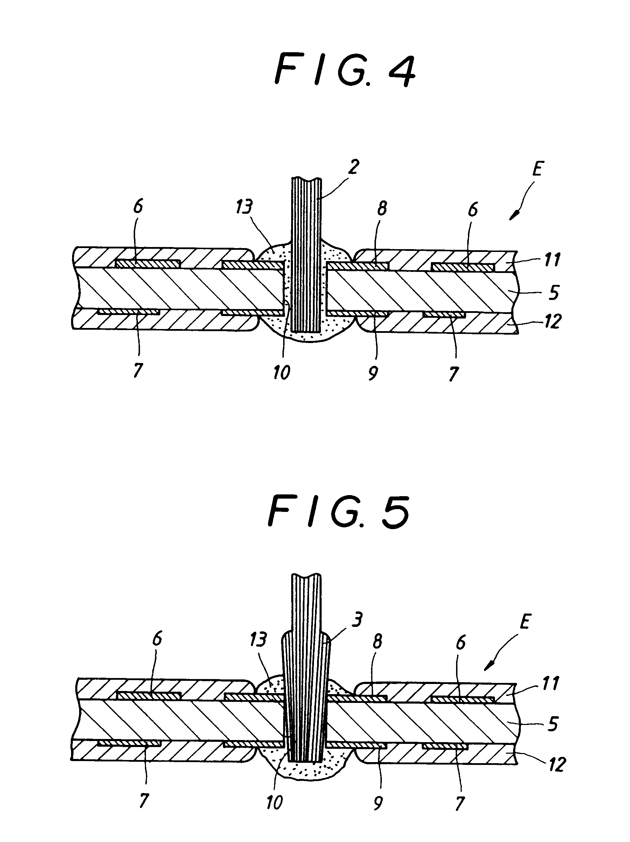

Figure 3 shows a connection device C according to the present invention. The connection device C is different from the connection device A in that the lead wires 2 are twisted to make twisted lines 4.

Firstly, of the connection devices A, B and C having the above-mentioned construction, it is described how the devices A and B are used to electrically connect given circuits on the double-sided printed wiring board E.

As shown in Figures 4 and 5, the double-sided printed wiring board E is provided with wiring circuits 6, 7 and connection lands 8, 9 on both sides, the through hole 10 drilled in the middles of the connection lands 8, 9 and solder resists 11, 12 are applied to areas except for the areas which are soldered.

Solder 13 is absorbed into the through hole 10 because of capillary action of a plurality of fine lines comprising the lead wire 2 by inserting the lead wires 2 or 3 of the connection device A or B respectively into the through hole 10 of the double-sided printed wiring board, and putting the board into a solder bath, not shown, filled with melted solder.

A connection device G is constructed in such a manner that the lead wire 2 made of the twisted lines 4 of the connection device C shown in Figure 3 and the cone-shaped lead ends (tips) shown in Figure 2 are combined with each other.

In the completed condition of the soldering of the connection lands 8, via the through hole 10 after the double-sided printed wiring board E is taken up from the solder bath, as shown in Figures 4 and 5, solder 13 is well absorbed into the through hole 10 and set on the surfaces of the connection lands 8, 9 with a swollen shape to electrically connect given circuits on the double-sided printed wiring board E via the through hole 10.

Moreover, since the connection devices A, B and C according to the present invention can be formed in the same shape as those of existing mounted parts, they can be mounted on a printed wiring board by matching the length of the lead wires 2 made of a plurality of fine lines for a lattice design of 2.54 mm or for pitches of usual parts.

Since the connection device C is soldered to the double-sided printed wiring board E in the same way as the connection device A, detailed description of the soldering is skipped.

In this embodiment, since the through hole 10 is easily filled with solder 13 and the soldering of the connection lands 8, 9 is made without fail, conductivity can be enhanced.

Moreover, since the device C can be mounted into the through hole 10 with a part mounter, the mounting work is easy. Since the cone-shaped lead wire 2 is easily inserted into the through hole and the cone-shaped portion 3 contacts the insides of the connection lands, the lead wire 2 does not easily come out.

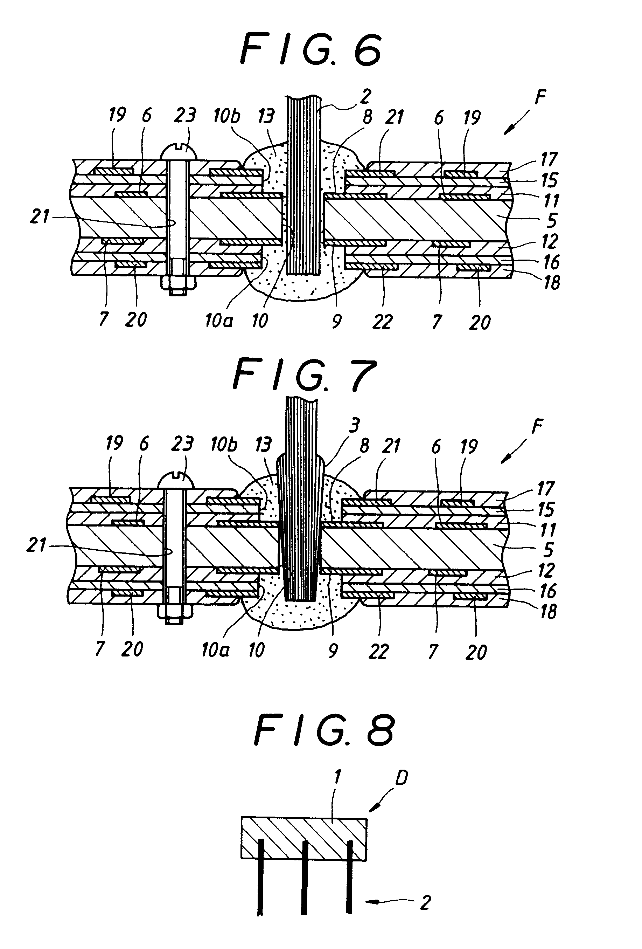

Figures 6 and 7 show a second embodiment. In this embodiment, it is described how the connection devices A, B and C are applied to a multi-layer printed wiring board F. The multi-layer printed wiring board F shown in Figures 6 and 7 is provided with wiring circuits 6, 7, 19 and 20 and connection lands 8, 9, 21 and 22 for connecting the given circuits to each other on each of an inner substrate 5 and outer substrates 15, 16, and through holes 10, 10a and 10b are drilled through the middles of the connection lands 8, 9, 21 and 22.

The exposed areas of the connection holes 8, 9 on the inner layer are made large to allow easy soldering by making the inner diameters of the through holes 10, 1 Oa and 10b larger on the outer layers than on the inner layer.

The inner and outer substrates are produced independently of each other by applying solder resists 11, 12, 17 and 18 to areas of the connection lands 8, 9, 21 and 22 except for the areas for solder 13.

The multi-layer printed wiring board F is assembled by laminating the inner and outer printed wiring boards and fixing them to each other with a plurality of screws 23 applied through a plurality of aligning holes 21.

Firstly, the lead wire 2 made of a plurality of fine lines of the connection devices A and B is inserted into the through holes 10, 10a and 10b of the multi- layer printed wiring board F, and the board F is put into a solder bath, not shown. Thus, solder is absorbed into the through holes 10, 1 Oa and 10b because of capillary action of the plurality of fine lines.

As shown in Figure 5, in the completed condition of the soldering of the tips 3 to the connection holes 10, 1 Oa and 1 Ob after the board F is taken up from the solder bath, the given wiring circuits of the multi-layer printed wiring board F are electrically connected to each other by the solder setting on the connection lands 21, 22 on the outer substrates with a swollen shape.

Since the connection device C is soldered to the double-sided printed wiring board E in the same way as the connection device A, detailed description of the soldering of the connection device C is skipped.

This embodiment can show the same operation and effects as those of the first embodiment.

As shown in Figure 8, the connection devices A, B and C used in the first and second embodiments may comprise two or three lead wires 2 which extend from one main body 1.

The connection devices according to the present invention not only can connect given wiring circuits to each other via through holes with ease and without fail but can be mounted into through holes with a part mounter for easy mounting.

## Claims

1. A connection device for electrically connecting given circuits on a double-sided or multilayer printed wiring board via through holes drilled in each of the printed wiring boards, said device comprising:
a main body made of insulating material; and
a bundle of twisted fine lines which is made of a plurality of fine lines and the lead tip of which is cone-shaped.
